# FASCICULE DE BREVET EUROPEEN

(11) **EP 2 324 516 B1**
(45) Date de publication et mention de la délivrance du brevet: **06.06.2012**
(21) Numéro de dépôt: 09740349.7
(22) Date de dépôt: 17.09.2009
(51) Int. Cl.: H03H 9/02, H03H 9/25, H03H 9/64

(54) **DISPOSITIF A ONDES ACOUSTIQUES D'INTERFACES**
AKUSTISCHES GRENZFLÄCHENWELLENELEMENT
INTERFACE ACOUSTIC WAVE DEVICE

(30) Priorité: 18.09.2008 FR 0805124
(43) Date de publication de la demande: 25.05.2011
(73) Titulaire: Etat Français représenté par le Délégué Général pour L'Armement, 94114 Arcueil Cedex (FR); Centre National de la Recherche Scientifique, 75794 Paris Cedex 16 (FR); Université de Franche-Comté, 25000 Besançon (FR)
(72) Inventeur: PETIT, Roger, F-35580 Guichen (FR); BALLANDRAS, Sylvain, F-25000 Besançon (FR); COURJON, Emilie, F-25000 Besançon (FR); GACHON, Dorian, 66750 Saint Cyprien (FR)
(86) Numéro de dépôt international: PCT/FR2009/001103
(87) Numéro de publication internationale: WO 2010/031924

(56) Documents cités:
- DE-A1-102004 049 498
- FR-A- 2 811 828
- US-A- 4 129 799
- US-A1- 2004 192 040
- COURJON E ET AL: "4E-1 Periodically Poled Transducers Built on Single Crystal Lithium Niobate Layers Bonded onto Silicon" ULTRASONICS SYMPOSIUM, 2007. IEEE, IEEE, PISCATAWAY, NJ, USA, 1 octobre 2007 (2007-10-01), pages 268-271, XP031194969 ISBN: 978-1-4244-1383-6
- DANIAU W ET AL: "A novel piezoelectric interdigital transducer for the excitation of high frequency surface acoustic waves" ULTRASONICS SYMPOSIUM, 2004 IEEE MONTREAL, CANADA 23-27 AUG. 2004, PISCATAWAY, NJ, USA,IEEE, vol. 1, 23 août 2004 (2004-08-23), pages 441-444, XP010783978 ISBN: 978-0-7803-8412-5

## Description

La présente invention concerne le domaine des dispositifs à ondes acoustiques et notamment celui des transducteurs aptes à fonctionner à très hautes fréquences, de quelques centaines de MHz jusqu'à plusieurs GigaHertz.

On connaît un certain nombre de demandes de brevets qui décrivent des dispositifs passifs pour le traitement de signaux RF, comportant des structures de peigne à électrodes inter-digitées et mettant en oeuvre le mécanisme connu sous le nom d'ondes d'interfaces. Ce type de dispositif nécessite la mise en oeuvre d'un film en polymère assurant une liaison élastique entre les matériaux, ce qui engendre des pertes acoustiques notables. Si certaines configurations permettent de s'affranchir d'une telle couche organique, elles nécessitent néanmoins la mise au point de techniques permettant l'intégration à l'interface dudit transducteur inter-digité, qui pose des difficultés technologiques notoires.

On connaît aussi les transducteurs à faible gap comportant des électrodes de largeur optimisée et dans lesquels la distance entre électrodes est extrêmement réduite. Toutefois, pour fonctionner par exemple à 1,6 GHz, des électrodes de largeur 1,5 µm, soit (λ/2), doivent être séparées par une distance de l'ordre de quelques centaines d'Angström, nécessitant une technologie délicate à mettre en oeuvre.

Pour résoudre ces inconvénients, on connaît la demande de brevet FR2811828 qui décrit un dispositif à ondes acoustiques de surfaces comprenant une couche de matériau ferroélectrique et un substrat et caractérisé en ce que la couche de matériau ferroélectrique est comprise entre une première électrode et une seconde électrode et en ce que la couche de matériau ferroélectrique comprend des premiers domaines de polarisation positive et des seconds domaines de polarisation négatives, les premiers et seconds domaines étant alternés.

Toutefois, ce type de dispositif comporte des inconvénients majeurs, à savoir :
- la nécessité d'affiner une membrane à des épaisseurs très faibles (de l'ordre de la longueur d'onde acoustique), rendant la manipulation de l'objet très délicate et généralement incompatible des procédés de fabrication industriels,
- une sensibilité importante aux effets externes nécessite une encapsulation sous vide pour pouvoir fonctionner correctement.
- Une densité de mode très élevée, malgré la possibilité de réduire celle-ci en affinant le transducteur (avec les difficultés évoquées plus haut), généralement peu propice à la fabrication de dispositifs à haute pureté spectrale
- une forte dérive en température de la fréquence de résonance des composants utilisant ce principe, lié au fait que les matériaux ferroélectriques couramment utilisés à cette fin (PZT, niobate de lithium, tantalate de lithium) présentent des propriétés élastiques très sensibles aux effets thermiques.

Le but de l'invention est de résoudre les inconvénients précités en proposant un dispositif à ondes acoustiques permettant de fonctionner à des fréquences supérieures au GHz sans difficultés de réalisation et comportant une grande insensibilité aux effets externes et, d'autre part, l'obtention de coefficients de qualité très élevés.

La solution apportée est un dispositif à ondes acoustiques d'interfaces comprenant au moins deux substrats et une couche de matériau ferroélectrique, cette dernière étant comprise entre une première électrode et une seconde électrode et comprenant des premiers domaines de polarisation positive et des seconds domaines de polarisation négative, les premiers et seconds domaines étant alternés, ce dispositif étant caractérisé en ce que l'ensemble, constitué par la première électrode, la couche de matériau ferroélectrique et la seconde électrode, est compris entre un premier substrat et un second substrat.

Selon une caractéristique particulière, la couche de matériau ferroélectrique comporte une première partie avec des premiers domaines de polarisation positive et des seconds domaines de polarisation négatives, les premiers et seconds domaines étant alternés, et une seconde partie uniformément polarisée.

Selon une caractéristique particulière permettant de constituer des zones de transfert d'énergie, un dispositif selon l'invention comporte au moins une cavité au niveau de la couche en matériau ferroélectrique et/ou de l'un au moins des substrats.

Selon une caractéristique additionnelle, un dispositif selon l'invention comporte au moins l'une des caractéristiques suivantes :
- une première partie avec des premiers domaines de polarisation positive et des seconds domaines de polarisation négative, les premiers et seconds domaines étant alternés, et une seconde partie uniformément polarisée, caractérisé en ce que des faces d'au moins une cavité constituent des frontières avec lesdites première et seconde parties et sont orthogonales à ces dernières,
- au moins l'un des substrats comporte au moins une rainure sur sa face en contact avec l'électrode, cette rainure constituant une cavité,
- une première partie avec des premiers domaines de polarisation positive et des seconds domaines de polarisation négative, les premiers et seconds domaines étant alternés, et une seconde partie uniformément polarisée, caractérisé en ce que la seconde partie comporte une troisième partie non recouverte par les électrodes et amincie de sorte à former des cavités entre cette troisième partie et chacun des premier et second substrats, provoquant une rupture d'impédance acoustique propice à la réflexion des ondes et leur confinement au voisinage du transducteur,
- une première partie avec des premiers domaines de polarisation positive et des seconds domaines de polarisation négatives, les premiers et seconds domaines étant alternés, et une seconde partie constituée de premiers ou de seconds domaines séparés par des cavités.

L'invention concerne aussi un résonateur comportant au moins un dispositif selon l'invention.

D'autres avantages et caractéristiques apparaîtront dans la description d'un mode de réalisation de l'invention au regard des figures annexées parmi lesquelles :
- la figure 1 présente un schéma général d'un dispositif à ondes d'interfaces selon un mode de réalisation particulier de l'invention.
- la figure 2 présente un schéma d'une première variante de réalisation d'un résonateur mettant en oeuvre un dispositif à ondes d'interfaces selon l'invention.
- la figure 3 présente un schéma d'une seconde variante de réalisation d'un résonateur mettant en oeuvre un dispositif à ondes d'interfaces selon l'invention.
- la figure 4 présente un schéma d'une troisième variante de réalisation d'un résonateur mettant en oeuvre un dispositif à ondes d'interfaces selon l'invention,
- la figure 5 présente un schéma d'une quatrième variante de réalisation d'un résonateur mettant en oeuvre un dispositif à ondes d'interfaces selon l'invention.

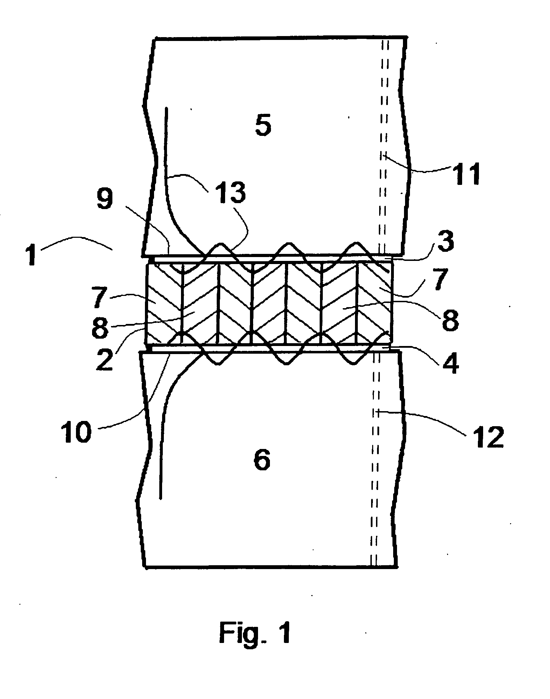

La figure 1 présente un schéma d'un dispositif à ondes acoustiques d'interfaces selon une première variante de réalisation de l'invention. Ce dispositif à ondes acoustiques d'interfaces 1 comprenant une couche 2 de matériau ferroélectrique comprise entre une première électrode 3 et une seconde électrode 4, l'ensemble, constitué par la première électrode 3, la couche de matériau ferroélectrique 2 et la seconde électrode 4, étant lui-même compris entre un premier substrat 5 et un second substrat 6. La couche 2 de matériau ferroélectrique comporte des premiers domaines de polarisation positive 7 et des seconds domaines de polarisations négatives 8, les premiers et seconds domaines étant alternés.

Dans cet exemple de réalisation, la couche 2 de matériau ferroélectrique est en niobate de lithium tandis que les première et seconde électrodes sont en or déposées sur la couche 2 de matériau ferroélectrique par vaporisation ou pulvérisation cathodique sous vide. Les premier et second substrats sont en silicium et sont collés respectivement sur les surfaces libres 9, 10 des première et seconde électrodes, 3, 4, par compression métallique. Des premier et second vias 11, 12 sont creusés respectivement dans les premier et second substrats 7, 8 pour permettre une reprise des contacts électriques.

Sur cette première figure sont aussi représentés l'évolution d'une onde 13 de longueur d'onde λ au sein du dispositif 1. Cette onde se propage pratiquement sans pertes au niveau des interfaces entre ledit ensemble et chacun des substrats tandis qu'au sein de chacun des substrats, l'onde décroît de façon exponentielle (onde évanescente).

La fabrication d'une telle couche 2 de matériau ferroélectrique est connue de l'homme de l'art, et notamment explicitée dans la demande de brevet FR2811828.

Pour des applications dans le domaine des transducteurs, on peut ainsi réaliser des structures avec inversion de domaines de pas de l'ordre de quelques centaines de nanomètres donc tout à fait adaptées à des applications hautes fréquences. En effet selon l'invention le pas du réseau est de l'ordre de la longueur d'onde acoustique. La fréquence est obtenue en première approximation en divisant la vitesse de phase de l'onde par le pas du réseau, ce dernier correspondant à une alternance de polarisation ferroélectrique (top/down) étant égal à la longueur d'onde acoustique λ.

En effet, en recouvrant la couche de matériau ferroélectrique par une seconde électrode, on peut exciter la structure ainsi réalisée de façon dynamique. En alternant des domaines de polarisation positive et de polarisation négative on alterne extensions et compressions de matière au niveau de la couche de matériau ferroélectrique de manière à générer des interférences acoustiques constructives, se propageant préférentiellement dans le plan de la couche (ayant ainsi une fonction de guide) plutôt que dans le volume. En effet la vitesse de propagation des ondes élastiques guidées dans la couche est plus faible que la vitesse de propagation des ondes élastiques dans le substrat. Il est toutefois également possible d'exciter des ondes présentant des polarisations complexes (mélangeant des déplacements elliptiques et cisaillement) ou encore des ondes de polarisation majoritairement longitudinale. En utilisant des substrats à vitesses d'ondes élastiques élevées (saphir, carbure de silicium, carbone-diamant, etc.), on peut ainsi piéger dans la couche ferroélectrique de telles ondes, présentant des vitesses de propagation égales à celles des ondes de volume correspondantes. L'utilisation d'un matériau dans lequel les ondes élastiques se propagent moins vite que dans le niobate de lithium (typiquement du tantalate de lithium) permet également le guidage de telles ondes avec le silicium ou le niobate de lithium comme substrats supérieur et inférieur par exemple. L'utilisation de quartz comme substrat est également possible avec un transducteur en tantalate de lithium, en choisissant judicieusement les angles de coupe de ce matériau pour favoriser l'effet de guidage recherché. Un exemple de coupe de quartz favorable correspond à la coupe (YXt)/90° en notation conforme à la norme IEEE std-176 révision 1949 (IEEE Standard on piezoelectricity Std 176 -1949, Proc.of the IRE, vol. 37, pages 1378-1395, 1949) pour laquelle les ondes de Rayleigh (non couplées par piézoélectricité) se propagent à 3800 m.s⁻¹ et le rayonnement acoustique dans le volume s'avère pour une vitesse de phase de plus de 4100 m.s⁻¹, soit notablement plus que la vitesse des ondes de polarisation elliptique dans les transducteurs à domaines ferroélectriques alternés.

Il est alors possible de définir à la surface du substrat un unique transducteur qui présente une admittance caractéristique bien identifiée, utilisée en combinaison d'autres transducteurs du même type (mais dont la fréquence centrale est différente) de façon à réaliser des filtres en réseaux, en échelle ou en treillis, ou bien définir un transducteur d'entrée et un transducteur de sortie.

Selon ce concept inventif, il est possible de réaliser de manière très directe des fonctions de transduction permettant d'élaborer des transducteurs avec des spécifications données.

La période des domaines 7, 8, est alors équivalente à la période entre électrodes de même polarité au sein des structures inter-digitées de l'art connu. Pour une largeur de trait identique (utilisée pour réaliser les électrodes du transducteur inter-digité ou pour définir la largeur d'un domaine du transducteur à polarisation alternée), la présente invention permet un gain en fréquence de fonctionnement d'un facteur proche de 2, comme déjà mentionné dans la demande de brevet FR2811828.

Notamment il est possible d'influencer la directionnalité des ondes acoustiques de surface en créant des éléments neutres en polarisation qui modifie la phase des ondes en perturbant localement le pas des domaines alternés. La propagation des ondes est alors perturbée de manière non symétrique, privilégiant une direction plutôt que l'autre.

Il est également possible de réaliser des dispositifs à ondes de surface avec des fonctions de filtrage très sélectives en longueur d'onde et de manière plus simple que dans l'art connu. En effet, le recouvrement des électrodes permet de définir la forme de la réponse impulsionnelle du transducteur. Cette approche connue dans le domaine des peignes inter-digités sous le nom d'apodisation de transducteur est très contraignante en termes de réalisation technologique. Dans le cas présent, cette fonction est réalisée avec des électrodes pleines (et non distribuées), simplifiant ainsi notablement la mise en oeuvre de la technique.

Par ailleurs, un résonateur peut par exemple être constitué en utilisant deux dispositifs 1 selon ce premier mode de réalisation de l'invention, une zone de transfert d'énergie dont les dimensions sont optimisées de façon connue pour permettre le meilleur piégeage possible des ondes.

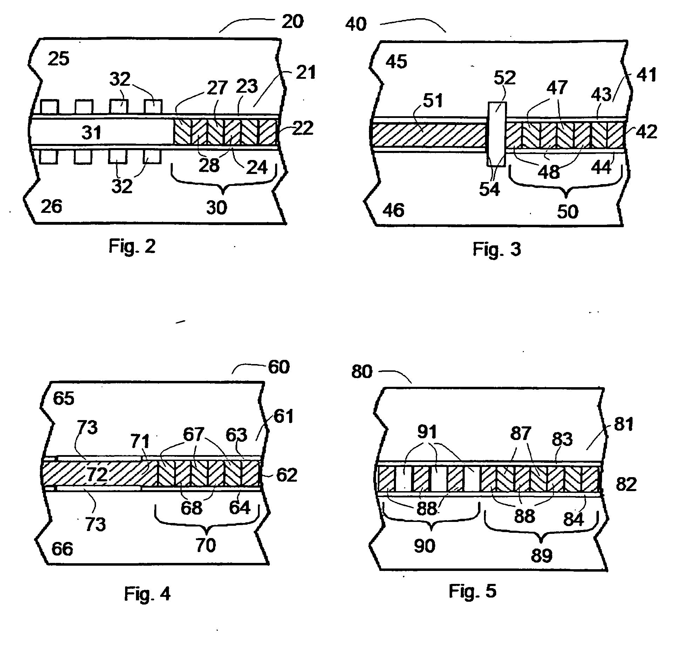

Les figures 2 à 5 présentent chacune un mode de réalisation d'un résonateur comportant une structure réfléchissante destinées à la mise en oeuvre d'un miroir de Bragg pour ondes d'interfaces excitées par un transducteur mettant en oeuvre un dispositif à ondes d'interfaces selon l'invention.

Dans le cadre de la figure 2, le résonateur 20 comporte un dispositif à ondes acoustiques d'interfaces 21 comprenant une couche 22 de matériau ferroélectrique comprise entre une première électrode 23 et une seconde électrode 24, l'ensemble, constitué par la première électrode 23, la couche de matériau ferroélectrique 22 et la seconde électrode 24, étant lui-même compris entre un premier substrat 25 et un second substrat 26. La couche 22 de matériau ferroélectrique comporte une première partie 30 avec des premiers domaines de polarisation positive 27 et des seconds domaines de polarisation négative 28, les premiers et seconds domaines étant alternés, et une seconde partie 31 uniformément polarisée. Au niveau de cette deuxième partie 31, chacun des premier et second substrats 25, 26 comporte des rainures 32 sur sa face en contact avec l'électrode correspondante. Ces rainures sont réalisées par gravure.

La fonction de ces rainures est de constituer des zones de transfert d'énergie (diffraction des ondes, avec réflexion en phase vers le transducteur émetteur).

Dans le cadre de la figure 3, le résonateur 40 comporte un dispositif à ondes acoustiques d'interfaces 41 comprenant une couche 42 de matériau ferroélectrique comprise entre une première électrode 43 et une seconde électrode 44, l'ensemble, constitué par la première électrode 43, la couche de matériau ferroélectrique 42 et la seconde électrode 44, étant lui-même compris entre un premier substrat 45 et un second substrat 46. La couche 42 de matériau ferroélectrique comporte une première partie 50 avec des premiers domaines de polarisation positive 47 et des seconds domaines de polarisation négative 48, les premiers et seconds domaines étant alternés, et une seconde partie 51 uniformément polarisée. Une cavité 52 sépare les première et seconde partie 50, 51. Elle a une section rectangulaire dont la hauteur est supérieure au dit ensemble si bien que chacun des substrats en comporte une partie. Elle comporte deux faces 54 constituant des frontières avec lesdites première et seconde parties et étant orthogonales à ces dernières. Ainsi, ces faces 54 sont orthogonales à la direction de propagation des ondes au sein du dispositif. La fonction de cette cavité est de constituer des zones de transfert d'énergie. Ce type de résonateur permet aussi, par l'application d'une différence de potentiel sur les électrodes, le calage en fréquence du dispositif par création d'un champ électrique statique dans la couche en matériau ferroélectrique. En effet, le signe des constantes diélectriques n'étant pas affecté par la polarisation ferroélectrique, mais l'amplitude des dites constantes pouvant être modifiée par application d'un champ électrique statique, il est possible d'utiliser ce phénomène pour modifier la vitesse de propagation des ondes et par voie de conséquence, la fréquence de résonance du dispositif.

Dans le cadre de la figure 4, le résonateur 60 comporte un dispositif à ondes acoustiques d'interfaces 61 comprenant une couche 62 de matériau ferroélectrique comprise entre une première électrode 63 et une seconde électrode 64, l'ensemble, constitué par la première électrode 63, la couche de matériau ferroélectrique 62 et la seconde électrode 64, étant lui-même compris entre un premier substrat 65 et un second substrat 66. La couche 62 de matériau ferroélectrique comporte une première partie 70 avec des premiers domaines de polarisation positive 67 et des seconds domaines de polarisation négative 68, les premiers et seconds domaines étant alternés, et une seconde partie 71 uniformément polarisée et une troisième partie 72 uniformément polarisée placée entre lesdites première et seconde parties non recouverte par les électrodes et amincie de sorte à former des cavités 73 entre cette troisième partie et chacun des premier et second substrats. La fonction de ces cavités est de constituer des zones de transfert d'énergie.

Dans le cadre de la figure 5, le résonateur 80 comporte un dispositif à ondes acoustiques d'interfaces 81 comprenant une couche 82 de matériau ferroélectrique comprise entre une première électrode 83 et une seconde électrode 84, l'ensemble, constitué par la première électrode 83, la couche de matériau ferroélectrique 6 et la seconde électrode 64, étant lui-même compris entre un premier substrat 65 et un second substrat 86. La couche 82 de matériau ferroélectrique comporte une première partie 89 avec des premiers domaines de polarisation positive 87 et des seconds domaines de polarisation négative 88, les premiers et seconds domaines étant alternés, et une seconde partie 90 comportant des domaines de polarisation négative 88 séparés par des cavités 91. Là encore, la fonction de ces cavités est de constituer des zones de transfert d'énergie.

Les résonateurs selon l'invention sont de haute qualité immunisé des atteintes extérieures par la présence des substrats de chaque côté dudit ensemble et fonctionnant à une fréquence double de celle d'un transducteur à peigne inter-digité classique pour une même résolution lithographique.

Par ailleurs, de nombreuses modifications peuvent être apportées aux procédés décrits sans sortir du cadre de l'invention. Ainsi, de nombreux matériaux ferroélectriques mono, poly ou multicristallins tels que l'oxyde de plomb, titane zirconium, le tantalate de lithium, le niobate de lithium, le niobate de potassium, PZT, PbTiO3 (toutes les céramiques ferroélectriques, les relaxeurs et les cristaux céramiques de type PMN-PT) sont utilisables pour créer la zone de transduction à domaines de polarisation alternée, avec une préférence pour les monocristaux ou les matériaux épitaxiés afin de préserver une qualité de propagation acoustique que l'on sait liée à la qualité du réseau cristallin.

Il en est de même pour le substrat qui pourrait par exemple être réalisé par croissance de films en carbone-diamant épais notamment sur des épaisseurs comprises entre 20 et 100µm ou en silicium, saphir, carbure de silicium, mais aussi le quartz en choisissant les coupes selon leurs propriétés de guidage d'ondes en surface (cf. remarque dans le corps du texte), le niobate de lithium lui-même (idem précaution du choix des coupes selon les vitesses de propagation en surface), et plus généralement tout matériau mono-cristallin dont les vitesses des ondes en surface dépassent celles des ondes de même polarisation dans le transducteur. Il existe aussi des configurations pour lesquelles des ondes d'interfaces (essentiellement de polarisation longitudinale) peuvent être guidées au-delà de la vitesse de rayonnement dans les substrats. Il faut alors circonstancier les points de fonctionnement, soit le rapport épaisseur du transducteur/longueur d'ondes, afin de minimiser les pertes de propagation par rayonnement dans les substrats.

Par ailleurs, les électrodes peuvent être réalisées en tout matériau électriquement conducteur.

## Revendications

1. Dispositif à ondes acoustiques d'interfaces (1) comprenant au moins deux substrats et une couche (2, 22, 42, 62, 82) de matériau ferroélectrique, cette dernière étant comprise entre une première électrode (3, 23, 43, 63, 83) et une seconde électrode (4, 24, 44, 64, 84) et comprenant des premiers domaines de polarisation positive (7, 27, 47, 67, 87) et des seconds domaines de polarisation négative (8, 28, 48, 68, 88), ces premiers et seconds domaines étant alternés, ce dispositif étant **caractérisé en ce que** l'ensemble, constitué par la première électrode (3, 23, 43, 63, 83), la couche (2, 22, 42, 62, 82) de matériau ferroélectrique et la seconde électrode (4, 24, 44, 64, 84)), est compris entre un premier substrat (5, 25, 45, 65, 85) et un second substrat (6, 26, 46, 66, 86).

2. Dispositif à ondes acoustiques d'interfaces selon la revendication 1, **caractérisé en ce que** la couche (2) de matériau ferroélectrique comporte une première partie (30, 50, 70, 89) avec des premiers domaines de polarisation positive (27, 47, 67, 87) et des seconds domaines (28, 48, 68, 88) de polarisation négative, les premiers et seconds domaines étant alternés, et une seconde partie (31, 51, 71) uniformément polarisée.

3. Dispositif à ondes acoustiques d'interfaces selon l'une quelconque des revendications 1 et 2, **caractérisé en ce que** la couche de matériau ferroélectrique comporte au moins une cavité (52, 91).

4. Dispositif à ondes acoustiques d'interfaces selon la revendication 3 et comportant une première partie avec des premiers domaines de polarisation positive et des seconds domaines de polarisation négative, les premiers et seconds domaines étant alternés, et une seconde partie uniformément polarisée, **caractérisé en ce que** des faces (54) d'au moins une cavité (52) constituent des frontières avec lesdites première et seconde parties (50, 51) et sont orthogonales à ces dernières.

5. Dispositif à ondes acoustiques d'interfaces selon l'une quelconque des revendications 1 à 4, **caractérisé en ce qu'**au moins l'un des substrats comporte au moins une rainure (32) sur sa face en contact avec l'électrode, cette rainure constituant une cavité.

6. Dispositif à ondes acoustiques d'interfaces selon la revendication 3 et comportant une première partie avec des premiers domaines de polarisation positive et des seconds domaines de polarisation négative, les premiers et seconds domaines étant alternés, et une seconde partie uniformément polarisée, **caractérisé en ce que** la seconde partie comporte une troisième partie (72) non recouverte par les électrodes et amincie de sorte à former des cavités (73) entre cette troisième partie et chacun des premier et second substrats.

7. Dispositif à ondes acoustiques d'interfaces selon la revendication 3 et comportant une première partie (89) avec des premiers domaines de polarisation positive et des seconds domaines de polarisation négative, les premiers et seconds domaines étant alternés, et une seconde partie (90) constituée de premiers ou de seconds domaines séparés par des cavités (91).

8. Résonateur comportant un dispositif selon l'une quelconque des revendications 1 à 7.

9. Filtre de bande comportant un dispositif selon l'une quelconque des revendications 1 à 7.

10. Résonateur, filtre de bande ou capteur comportant un dispositif selon l'une quelconque des revendications 1 à 7 accordable en fréquence par application d'une différence de potentiel sur les électrodes créant un champ statique dans le matériau ferroélectrique

## Claims

1. Interface acoustic wave device (1) comprising at least two substrates and one layer (2, 22, 42, 62, 82) made of ferroelectric material, said layer being provided between a first electrode (3, 23, 43, 63, 83) and a second electrode (4, 24, 44, 64, 84) and comprising first positive polarization domains (7, 27, 47, 67, 87) and second negative polarization domains (8, 28, 48, 68, 88), said first and second domains being alternate, said device being **characterized in that** the assembly, formed by the first electrode (3, 23, 43, 63, 83), the layer (2, 22, 42, 62, 82) of ferroelectric material and the second electrode (4, 24, 44, 64, 84), is provided between a first substrate (5, 25, 45, 65, 85) and a second substrate (6, 26, 46, 66, 86).

2. Interface acoustic wave device according to claim 1, **characterized in that** the layer (2) of ferroelectric material comprises a first part (30, 50, 70, 89) with first positive polarization domains (27, 47, 67, 87) and second negative polarization domains (28, 48, 68, 88), the first and second domains being alternate, and a second uniformly polarized part (31, 51, 71).

3. Interface acoustic wave device according to any one of claims 1 and 2, **characterized in that** the layer of ferroelectric material comprises at least one recess (52, 91).

4. Interface acoustic wave device according to claim 3 and comprising a first part with first positive polarization domains and second negative polarization domains, the first and second domains being alternate, and a second uniformly polarized part, **characterized in that** faces (54) of at least one recess (52) constitute borders with said first and second parts (50, 51) and are orthogonal thereto.

5. Interface acoustic wave device according to any one of claims 1 to 4, **characterized in that** at least one of the substrates comprises at least one groove (32) on its face in contact with the electrode, said groove constituting a recess.

6. Interface acoustic wave device according to claim 3 and comprising a first part with first positive polarization domains and second negative polarization domains, the first and second domains being alternate, and a second uniformly polarized part, **characterized in that** the second part comprises a third part (72) which is not covered by the electrodes and thinned so as to form recesses (73) between said third part and each one of the first and second substrates.

7. Interface acoustic wave device according to claim 3 and comprising a first part (89) with first positive polarization domains and second negative polarization domains, the first and second domains being alternate, and a second part (90) constituted by first or second domains separated by recesses (91).

8. Resonator comprising a device according to any one of claims 1 to 7.

9. Band filter comprising a device according to any one of claims 1 to 7.

10. Resonator, band filter or sensor comprising a device according to any one of claims 1 to 7, frequency-tunable by application of a potential difference across the electrodes creating a static field in the ferroelectric material.

## Patentansprüche

1. Grenzflächenakustikwellen-Vorrichtung (1) umfassend mindestens zwei Substrate und eine Schicht (2, 22, 42, 62, 82) aus ferroelektrischem Material, wobei letztere zwischen einer ersten Elektrode (3, 23, 43, 63, 83) und einer zweiten Elektrode (4, 24, 44, 64, 84) liegt, und umfassend erste Bereiche mit positiver Polarisierung (7, 27, 47, 67, 87) und zweite Bereiche mit negativer Polarisierung (8, 28, 48, 68, 88), wobei diese ersten und zweiten Bereiche abwechselnd sind, wobei diese Vorrichtung **dadurch gekennzeichnet ist, dass** die Gesamtheit bestehend aus der ersten Elektrode (3, 23, 43, 63, 83), der Schicht (2, 22, 42, 62, 82) aus ferroelektrischem Material und der zweiten Elektrode (4, 24, 44, 64, 84) zwischen einem ersten Substrat (5, 25, 45, 65, 85) und einem zweiten Substrat (6, 26, 46, 66, 86) liegt.

2. Grenzflächenakustikwellen-Vorrichtung nach Anspruch 1, **dadurch gekennzeichnet, dass** die Schicht (2) aus ferroelektrischem Material ein erstes Teil (30, 50, 70, 81) mit ersten Bereichen mit positiver Polarisierung (27, 47, 67, 87) und zweiten Bereichen (28, 48, 68, 88) mit negativer Polarisierung, wobei die ersten und zweiten Bereiche abwechselnd sind, und ein gleichförmig polarisiertes zweites Teil (31, 51, 71) umfasst.

3. Grenzflächenakustikwellen-Vorrichtung nach einem der Ansprüche 1 und 2, **dadurch gekennzeichnet, dass** die Schicht aus ferroelektrischem Material mindestens einen Hohlraum (52, 91) umfasst.

4. Grenzflächenakustikwellen-Vorrichtung nach Anspruch 3 und umfassend ein erstes Teil mit ersten Bereichen mit positiver Polarisierung und zweiten Bereichen mit negativer Polarisierung, wobei die ersten und zweiten Bereiche abwechselnd sind, und ein gleichförmig polarisiertes zweites Teil, **dadurch gekennzeichnet, dass** die Seiten (54) von mindestens einem Hohlraum (52) Grenzen zum ersten und zweiten Teil (50, 51) bilden und orthogonal zu diesen sind.

5. Grenzflächenakustikwellen-Vorrichtung nach einem der Ansprüche 1 bis 4, **dadurch gekennzeichnet, dass** mindestens eines der Substrate mindestens eine Nut (32) auf seiner Seite in Kontakt mit der Elektrode umfasst, wobei diese Nut einen Hohlraum bildet.

6. Grenzflächenakustikwellen-Vorrichtung nach Anspruch 3 und umfassend ein erstes Teil mit ersten Bereichen mit positiver Polarisierung und zweiten Bereichen mit negativer Polarisierung, wobei die ersten und zweiten Bereiche abwechselnd sind, und ein gleichförmig polarisiertes zweites Teil, **dadurch gekennzeichnet, dass** das zweite Teil ein von den Elektroden nicht abgedecktes drittes Teil (72) umfasst, das solchermaßen verdünnt ist, dass es zwischen dem dritten Teil und jedem des ersten und zweiten Substrats Hohlräume (73) bildet.

7. Grenzflächenakustikwellen-Vorrichtung nach Anspruch 3 und umfassend ein erstes Teil (89) mit ersten Bereichen mit positiver Polarisierung und zweiten Bereichen mit negativer Polarisierung, wobei die ersten und zweiten Bereiche abwechselnd sind, und ein zweites Teil (90) bestehend aus durch Hohlräume (91) getrennte erste oder zweite Bereiche.

8. Resonator umfassend eine Vorrichtung nach einem der Ansprüche 1 bis 7.

9. Bandfilter umfassend eine Vorrichtung nach einem der Ansprüche 1 bis 7.

10. Resonator, Bandfilter oder Sensor umfassend eine Vorrichtung nach einem der Ansprüche 1 bis 7 und in der Frequenz abstimmbar durch Anwendung eines Potentialunterschiedes auf die Elektroden unter Erzeugung eines statischen Feldes im ferroelektrischem Material.
